(19) **Europäisches Patentamt**

**European Patent Office**

**Office européen des brevets**

(11) **EP 1 278 103 A1**

(12) **EUROPEAN PATENT APPLICATION**

(43) Date of publication:
**22.01.2003 Bulletin 2003/04**

(51) Int Cl.⁷: **G03F 7/20**, G03F 9/00

(21) Application number: **02255085.9**

(22) Date of filing: **19.07.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **20.07.2001 EP 01306260**

(71) Applicant: **ASML Netherlands B.V.**
**5503 LA Veldhoven (NL)**

(72) Inventors:
• **Hoogenraad, Johannes Herman**
**3992 PL Houten (NL)**
• **Nayak Puttur, Vasudeva**
**5631 BB Eindhoven (NL)**

(74) Representative: **Leeming, John Gerard**
**J.A. Kemp & Co.,**
**14 South Square,**
**Gray's Inn**
**London WC1R 5JJ (GB)**

(54) **Lithographic apparatus**

(57)    A lithographic projection apparatus with a pre-alignment unit for determining the position and orientation of the substrate, comprising an edge sensor for determining the distance of the edge of the substrate along a measurement axis from an axis of rotation; means for rotating the substrate about said axis of rotation in order to vary the part of the edge of the substrate that coincides with the measurement axis; means for determining, from the determined distances of the edge of the substrate from the axis of rotation and the corresponding angle of rotation of the substrate, the position and orientation of the substrate.

Fig. 2

EP 1 278 103 A1

**Description**

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor $M$ (generally < 1), the speed $V$ at which the substrate table is scanned will be a factor $M$ times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

In apparatus of this kind there is a requirement that the substrate (for example, a wafer) must be delivered to the substrate table within a predetermined range from a predetermined position and with a known translational and rotational offset from the predetermined position. This is typically performed by a pre-alignment unit, or "prealigner", which is part of a wafer handling system. The prealigner determines the orientation of the wafer with respect to the prealigner, positions the wafer such that it will arrive at the wafer table within specification and determines what the remaining offset from the predetermined position will be.

It has previously been known to pre-align wafers by mechanically pressing one edge or one corner of the wafer against a known surface or pair of surfaces. However this is disadvantageous because the achievable accuracy is relatively low, it is slow, it can result in chipping of the edge of the wafer, which may further reduce the accuracy, it can introduce contamination to the wafer, it can be affected by wear and wafer expansion, it cannot detect notches (e. g. which may be used to mark orientation of the wafer) and it is typically limited in the range of wafer sizes that can be handled.

It has also been known to perform optical pre-alignment of round wafers. However, this has previously not been applicable to square or rectangular wafers.

It is an object of the present invention to provide a method and apparatus of pre-aligning polygonal substrates which avoids the risk of damage caused by chipping and is faster and more accurate than conventional methods.

This and other objects are achieved according to the invention in a lithographic apparatus as specified in the opening paragraph, characterized in that the apparatus further comprises a pre-alignment unit that determines the position and orientation of the substrate within the pre-alignment unit, comprising:

- means for rotating the substrate about an axis of rotation that is substantially perpendicular to the plane of the substrate;
- a non-contact edge sensor for determining the distance from said axis of rotation of the edge of the substrate along a measurement axis parallel to the plane of the substrate at a range of angles of rotation of the substrate;
- means for determining best-fit lines for at least two major edges of the substrate from the points associated with each edge that are defined by the determined distances and corresponding angles; and
- means for determining the position and orientation of the substrate within the pre-alignment unit from the determined best-fit lines;

and in that the pre-alignment unit is adapted to determine the position and orientation of a polygonal, planar substrate.

This apparatus is advantageous because, in use, it minimizes the risk of damage to the edges of the substrates during the pre-alignment process but does not require the substrate to have any rotational symmetry. Furthermore, it will be able to accurately determine the position and orientation of the substrate even if the corners are damaged or one has a notch.

In a preferred embodiment of the invention, the means for determining the position and orientation of the substrate establishes, from the intersecting of two of said best-fit lines, the position of at least one corner of the substrate. Where the corner of a substrate is damaged, this apparatus will be able to determine where the corner would have been, were the substrate n0ot damaged. Thus the position and orientation of the substrate will be accurately determined despite the substrate being damaged.

The means for determining best-fit lines may comprise a means for estimating the radius of curvature of the edge of the substrate for each determined point, defined by the determined distance and angle, by fitting a circle to each point and each adjacent point on either side; means for determining, from the radius of curvature estimates, which points are associated with corners of the substrate; and means for determining a best-fit line for the points between the adjacent points that are determined to be associated with corners.

In a yet further preferred embodiment of the invention, the apparatus further comprises a transport means, for positioning the substrate on the substrate table, which uses the results of the means for determining the position and orientation of the substrate in order to position the substrate on the substrate table within a predetermined range from a predetermined position and with a known translational and rotational offset from the predetermined position.

According to a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material;

characterized by determining the position and orientation of the substrate within a pre-alignment unit, prior to projecting the patterned beam of radiation onto the substrate, by:

- rotating the substrate about an axis of rotation substantially perpendicular to the plane of the substrate;
- using a non-contact edge sensor to determine the distance from said axis of rotation of the edge of the substrate along a measurement axis parallel to the plane of the substrate at a plurality of angles of rotation of the substrate;
- determining best-fit lines for at least two major edges of the substrate from the points associated with each edge that are defined by the determined distances and corresponding angles; and
- determining the position and orientation of the substrate within the pre-alignment unit from the determined best-fit lines;

and in that the pre-alignment unit is adapted to determine the position and orientation of a polygonal, planar substrate.

According to a further aspect of the invention there is provided a computer program for operating a lithographic projection apparatus, said computer program comprising code means for instructing the apparatus to perform the following steps:

- calculating the position and orientation of a substrate in a pre-alignment unit; and
- using the calculated position and orientation of the substrate to control a transport means for positioning the substrate on a substrate table within a predetermined range of positions and orientations and with a known offset;

characterized in that the code means for calculating the position and orientation of the substrate in the pre-alignment unit comprises code means for performing the following steps:

- receiving a first plurality of data elements from a non-contact edge sensor, each data element corresponding to a distance of the edge of the substrate from an axis of rotation of the pre-alignment unit;
- receiving a second plurality of data elements, each corresponding to an angle of rotation of the substrate about the axis of rotation of the pre-alignment unit associated with one of the first plurality of data elements;
- calculating best-fit lines for at least two major edges of the substrate from first and second data elements associated with each edge; and
- calculating the position and orientation of the substrate in the pre-alignment unit from the best-fit lines;

and in that the pre-alignment unit is adapted to determine the position and orientation of a polygonal, planar substrate.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;
Figure 2 depicts a schematic representation of the pre-alignment unit according to the present invention;
Figure 3a depicts the relationship between the edge sensor co-ordinate system and the mark sensor co-ordinate system;
Figure 3b depicts the geometrical wafer co-ordinate system;
Figure 4 shows the steps used to determine the position and orientation of the wafer in the prealigner;
Figure 5 shows the offset between the edge sensor co-ordinate system and the geometrical wafer co-ordinate system;
Figure 6 shows the steps used to determine the offset between the edge sensor co-ordinate system and the geometrical wafer co-ordinate system.

In the Figures, corresponding reference symbols indicate corresponding parts.

Embodiment 1

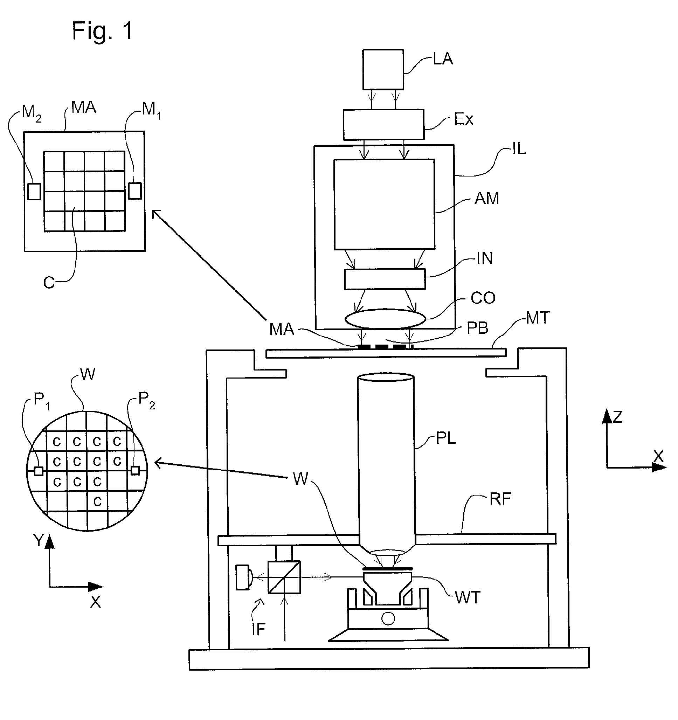

Figure 1 schematically depicts a lithographic projection apparatus according to a particular embodiment of the invention. The apparatus comprises:

- a radiation system Ex, IL, for supplying a projection beam PB of radiation *(e.g.* UV radiation) which in this particular case also comprises a radiation source LA;
- a first object table (mask table) MT provided with a mask holder for holding a mask MA *(e.g.* a reticle), and connected to first positioning means for accurately positioning the mask with respect to item PL;
- a second object table (substrate table) WT provided with a substrate holder for holding a substrate W *(e.g.* a resist-coated silicon wafer), and connected to second positioning means for accurately positioning the substrate with respect to item PL;
- a projection system ("lens") PL *(e.g.* a lens group, catadioptric or catoptric system) for imaging an irradiated portion of the mask MA onto a target portion C (*e.g.* comprising one or more dies) of the substrate W.

As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* Hg lamp, excimer laser, plasma discharge source or electron gun) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed ν, so that the projection beam PB is caused to scan over a mask image; concurrently, the substrate table WT is simultaneously moved in the same or opposite direction at a speed $V = Mν$, in which $M$ is the magnification of the lens PL (typically, $M = 1/4$ or $1/5$). In this manner, a relatively large target portion C can be exposed, without having to compromise on resolution.

The apparatus further comprises a prealigner that is, for example, mechanically isolated from the substrate table in order to prevent any vibrations being transferred from the prealigner to the substrate table. A substrate handler, such as a wafer handler robot, is used to deliver the wafer to the prealigner. Subsequently, a substrate handler transfers the wafer to the substrate table WT. This substrate handler may be the same one that delivered the wafer to the prealigner or it may be a second substrate handler. In order to ensure that placement accuracy is not lost, the substrate handler may be in a fixed position relative to the prealigner. Alternatively the substrate handler may be mechanically isolated from the prealigner during movement. In this case the substrate handler will subsequently temporarily couple to the prealigner, in order to define its position relative to the prealigner, prior to picking up the wafer. An example of such a system can be seen in EP-1 052 548-A2, incorporated herein by reference.

The prealigner can support the wafer, for example by way of a gas bearing, only limited mechanical contact used to secure the position of the wafer and to move it as required. The prealigner can also serve several other functions. The gas used in the gas bearing can be heated or cooled to aid in temperature stabilization of the wafer. The gas may also be charged to gradually discharge any built-up charge on the wafer and it may be filtered to be used to blow away any contaminants on the under side of the wafer. All of these uses reduce the likelihood of damage to the wafer and to help improve the positional accuracy. An example of such a prealigner can be seen in EP-1 052 546-A2, incorporated herein by reference.

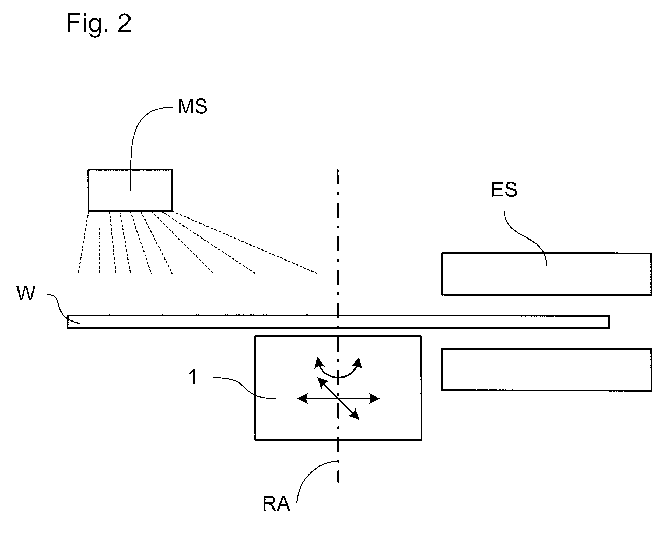

As schematically represented in Figure 2, the prealigner of the present invention is comprises a wafer support 1 for rotating a wafer W about an axis RA of the prealigner and for translating the wafer in the plane parallel to the wafer, an edge sensor ES for determining the distance of an edge of the wafer from the axis RA along an axis within the plane of the wafer (hereafter referred to as the radius) and a mark sensor MS for determining the location of marks on the surface of the wafer.

When the wafer W is delivered from the substrate handler to the prealigner it will be at an arbitrary and unknown position on the wafer support 1. The prealigner must therefore determine the position and orientation of the wafer accurately. Four co-ordinate systems are used in order to facilitate this. Two of these, the edge sensor co-ordinate system ESCS and the mark sensor co-ordinate system MSCS, are fixed relative to the prealigner. The remaining two, the geometrical wafer co-ordinate system GWCS and the wafer co-ordinate system WCS, are fixed relative to the geometry of and the marks on the wafer, respectively.

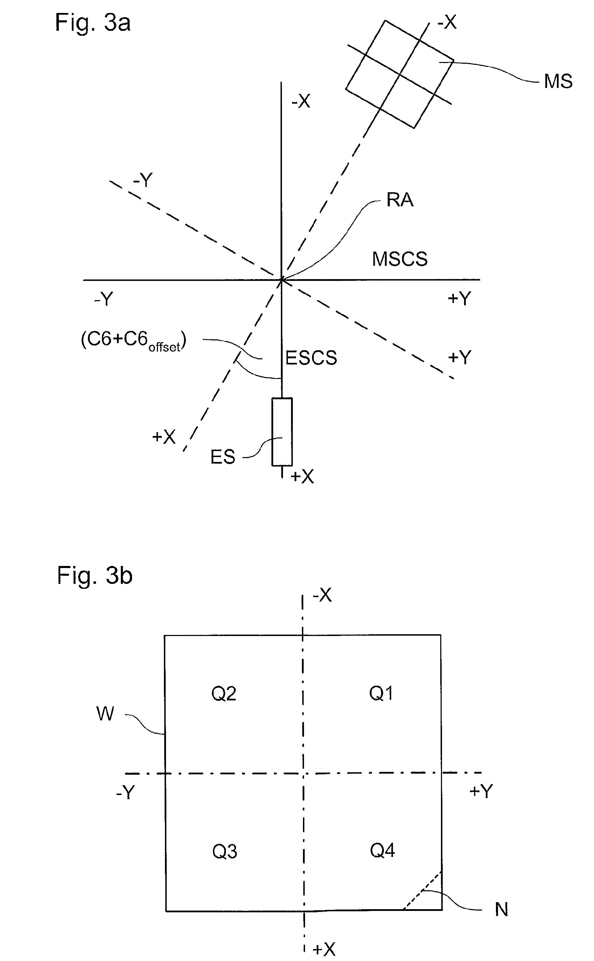

Figure 3a shows the relationship between the edge sensor co-ordinate system ESCS and the mark sensor co-ordinate system MSCS. The edge sensor co-ordinate system is defined by its X-axis which is the line passing through the axis of rotation RA of the prealigner and the pixel of the edge sensor ES that is furthest from the axis of rotation RA. The Y-axis is the line perpendicular to the X-axis, also passing through the axis of rotation RA of the prealigner. Both of these axes are in the plane of the wafer when loaded on the prealigner. The X-axis of the mark sensor co-ordinate system is the line passing through the axis of rotation RA of the prealigner and a set point on the mark sensor MS.

The mark sensor MS is arranged such that the respective axes of the edge sensor co-ordinate system and the mark sensor co-ordinate system are at a predetermined angle C6 (for example 60°). In practice, because of the mounting tolerances of the edge sensor ES and the mark sensor MS, there is a small offset in C6, the $C6_{offset}$. Therefore the total angle between the axes is $C6+C6_{offset}$. The $C6_{offset}$ may be determined during calibration procedures.

Figure 3b shows the geometrical wafer co-ordinate system GWCS. The axes of the GWCS are parallel to the edges of the wafer W, which in this case is square. The origin of the GWCS is the geometrical center of the square wafer. If a notch N is present, it will, for example, be in the fourth quadrant Q4 of the co-ordinate system. The wafer co-ordinate system WCS is defined by the position of specific marks, such as fiducials on the surface of the wafer. Therefore there will be an offset between the geometrical wafer co-ordinate system and the wafer co-ordinate system which will remain constant for each individual wafer.

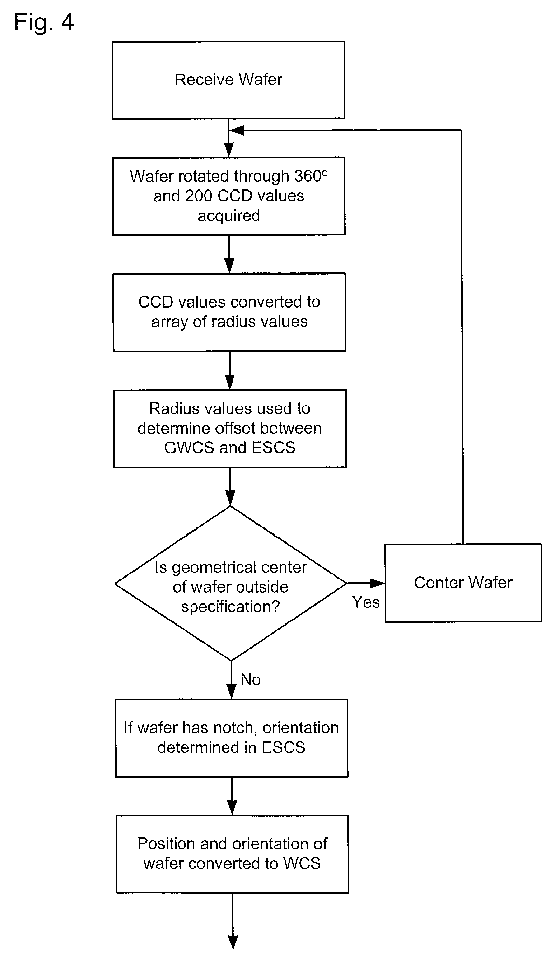

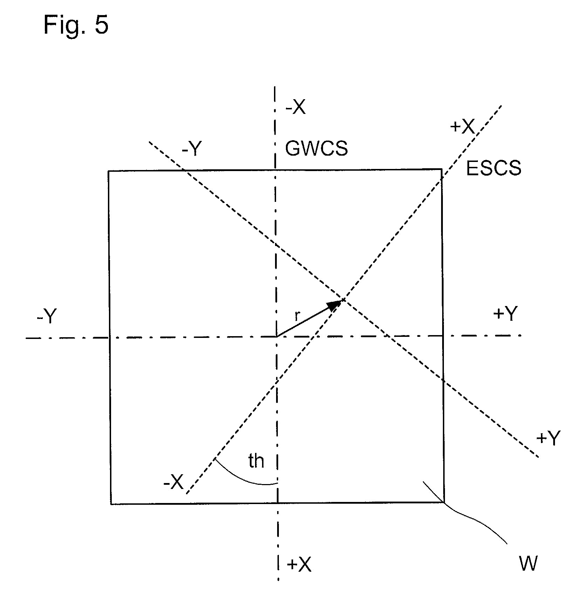

Figure 4 shows the steps followed in determining the position and orientation of the wafer W in the prealigner. After the wafer has been received in the prealigner it is rotated through 360° and, for example, two hundred values (referred to as CCD values), are obtained from the edge sensor ES which, in this embodiment, is a Charge Coupled Device. It will be apparent that the invention is not limited to the use of 200 CCD values and that more or fewer CCD values could also be obtained. The CCD values are then converted into an array of radius values, each associated with the angle at which the measurement was taken. In this case, the "radius" means the distance from the axis of rotation RA of the prealigner to the point on the edge of the wafer that was determined by the edge sensor ES. Each measurement point on the edge of the wafer is therefore characterized by a polar co-ordinate in the edge sensor co-ordinate system. From these values the relationship, or "offset vector", between the edge sensor co-ordinate system and the geometric wafer co-ordinate system can be determined (see below). As shown in Figure 5, this relationship can be characterized by the distance r between the origins of the two co-ordinate systems and the angle th, by which ESCS is rotated from the GWCS. For clarity, r will be denoted GWCS_ESCS_r_offset and th will be denoted GWCS_ESCS_th_offset.

A determination can then be made to see if the wafer W is within the specified range of acceptable locations (i.e. GWCS_ESCS_r_offset is compared to a preset threshold value). The acceptable offset may be, for example, within 0.5 mm. If the wafer is not within the specified limits, the wafer support may be used to move the wafer in order to re-center it. The measurement steps are then repeated for the new location. This cycle can be repeated as often as necessary in order to position the wafer within the specified range of locations.

If the wafer has a notch N, then the orientation of the notch in the edge sensor co-ordinate system ESCS may be determined (described further below). It is possible, however, that the notch orientation may be performed in advance of the pre-alignment. The orientation of the notch within the edge sensor co-ordinate system, GWCS_ESCS_theta, is the notch orientation as found within the geometric wafer co-ordinate system GWCS combined with the GWCS_ESCS_th_offset.

It is frequently more convenient to have these orientations in the mark sensor co-ordinate system. The angles may be converted as follows:

$$GWCS\_MSCS\_theta = GWCS\_ESCS\_theta + (C6+C6_{offset})$$

$$GWCS\_MSCS\_th\_offset = GWCS\_ESCS\_th\_offset + (C6+C6_{offset})$$

Note that, since the origins of the mark sensor co-ordinate system and the edge sensor co-ordinate system coincide:

$$GWCS\_MSCS\_r\_offset = GWCS\_ESCS\_r\_offset$$

In order to specify the position and orientation of the features on the wafer W (in the mark sensor co-ordinate system), the WCS_GWCS_offset vector, which is the difference between the geometrical wafer co-ordinate system and the wafer co-ordinate system, is added to the vector position of the geometric center of the wafer in the mark sensor co-ordinate system, which is a vector of length GWCS_MSCS_r_offset, at angle GWCS_MSCS_th_offset. The orientation of the features on the wafer is the sum of the WCS_GWCS_offset vector angle and GWCS_MSCS_theta.

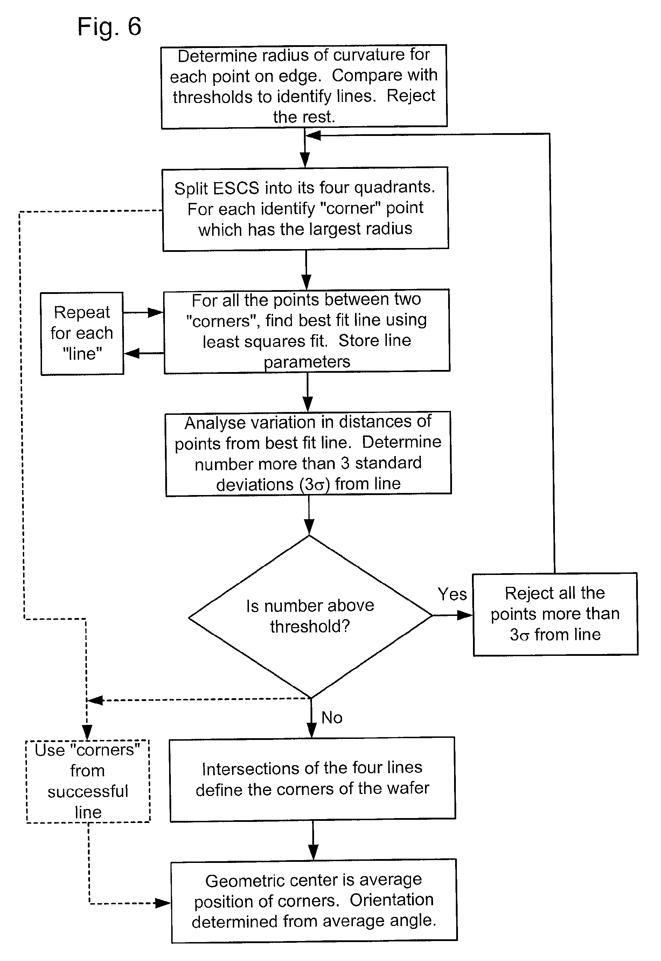

Figure 6 shows the steps required to determine the vector offset between the geometric wafer co-ordinate system and the edge sensor co-ordinate system. The first step is to make an estimate of the radius of curvature of the edge of the wafer for each measured point on the edge of the wafer. This can be calculated using the points on either side and fitting a circle to the three points. The measurement points are then classified as "line", "circle" or "other" by comparing the radius of curvature values to pre-set thresholds. Those points which are not classified as "lines" are rejected at this stage.

Next the edge sensor co-ordinate system ESCS is split into its four quadrants and the measurement points in each quadrant compared. Assuming that the wafer is not offset by more than a quarter of the width of the wafer, i. e. by more than the size of a single quadrant, each of the quadrants will contain one of the corners of the wafer. The measurement point in each quadrant which has the largest radius value is therefore considered to be a "corner point". Once the four "corners" have been identified, the remaining measurement points between adjacent corners, forming a line, will be considered to be those on one edge of the wafer. The measurement points are converted to Cartesian co-ordinates within the edge sensor co-ordinate system ESCS. A best fit line of the form y=AX+b is then determined for each of the edge lines using a standard least-squares method. The variation of the distances of the points in each edge line from the best fit line is then analyzed. Any points which are more than three standard deviations from the line are rejected. If the number of points rejected in this step exceeds a threshold, for example if there are any, then the procedure is repeated without the rejected points, from the point where the "corners" were determined, until the number of points rejected in this step is below the threshold.

Once the four edge lines have been found in this manner, the lines are extrapolated and the four points where they meet (that are closest to the origin - i.e. ignore the more distant intersections where the approximately parallel lines intersect) define the corners of the wafer W. Note if the wafer has a notch, then, at the notched corner, the corner found will be where the corner would have been if there was no notch.

Alternatively the corners used may be the "corners" found at the maximum radius in each quadrant in the successful procedure to find the edge lines. In this case, it is not necessary to find all four corners. If one corner is not recognizable, it may be deduced from the position of the other corners.

The four corners can then be used to find the offset vector between the edge sensor co-ordinate system ESCS and the geometrical wafer co-ordinate system GWCS. The average of the positions of the corners is the geometrical center of the wafer (which is the origin of the geometrical wafer co-ordinate system). This therefore defines r, also referred to above as the GWCS_ESCS_r_offset. The average of the angle of orientation of each of the lines connecting the corners will be th+45°, where th is the angle by which ESCS is rotated from the GWCS, referred to above as the GWCS_ESCS_th_offset.

A square wafer may be limited to only have a notch present on one of the four corners. Therefore, assuming that the wafer is limited such that the side of the wafer to be exposed has a predetermined direction, the orientation of the notch of a square wafer can be determined simply by determining on which of the corners the notch is located. The radius of curvature values, which may have been determined in a previous step or may be determined at this point, can be used to determine whether an identified corner has a notch or not. Thresholds can be set for the size of a notch in order to prevent spurious identification of false notches which may be caused by damage to corners.

The detection of the notch may be carried out after the prealigner has determined the position and orientation of the wafer. Alternatively, it may be performed in a pre-prealignment step. In this case a fast scan is made of the wafer in order to determine the position of the notch. This is then followed by the accurate wafer centering and position and orientation determination.

In some embodiments, using pre-orientated wafers without notches, the original orientation of the wafer is preserved and the notch detection step is not performed.

The method described above has been for a substrate with four sides and four corners (one of which may be notched), namely a square or rectangular substrate. It will be appreciated, however, that the method can be adapted for use with other polygonal substrates by, for example, determining a different number of "corner points" and finding best-fit lines for the points in between.

Whilst specific embodiments of the invention have been described above, it will be appreciated that the invention may be practiced otherwise than as described. The description is not intended to limit the invention.

**Claims**

**1.** A lithographic projection apparatus comprising:

- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate,

**characterized in that** the apparatus further comprises a pre-alignment unit that determines the position and orientation of the substrate within the pre-alignment unit, comprising:

- means for rotating the substrate about an axis of rotation that is substantially perpendicular to the plane of the substrate;
- a non-contact edge sensor for determining the distance from said axis of rotation of the edge of the substrate along a measurement axis parallel to the plane of the substrate at a range of angles of rotation of the substrate;
- means for determining best-fit lines for at least two major edges of the substrate from the points associated with each edge that are defined by the determined distances and corresponding angles; and
- means for determining the position and orientation of the substrate within the pre-alignment unit from the determined best-fit lines and **in that** the pre-alignment unit is adapted to determine the position and orientation of a polygonal, planar substrate.

**2.** A lithographic projection apparatus according to claim 1, wherein the means for determining the position and orientation of the substrate determines the position of at least one corner of the substrate from the intersection of two of said best-fit lines.

**3.** A lithographic projection apparatus according to claim 1 or 2, wherein the means for determining best-fit lines comprises:

- means for estimating the radius of curvature of the edge of the substrate for each point defined by a determined distance and angle by fitting a circle to each point and each adjacent point on either side;
- means for using the radius of curvature estimates to determine which points are associated with corners of the substrate; and
- means for determining a best-fit line for the points between adjacent said points determined to be associated with corners.

**4.** A lithographic projection apparatus according to any one of the preceding Claims, wherein the means for rotating the substrate rotates the substrate through 360°; and the non-contact edge sensor determines the distance of the edge of the substrate from the axis of rotation a predetermined number of times during this rotation.

**5.** A lithographic projection apparatus according to any one of the preceding Claims, further comprising a transport means for transporting the substrate from the pre-alignment unit to the substrate table; wherein the transport means uses the results of the means for determining the position and orientation of the substrate to position the substrate on the substrate table within a predetermined range from a predetermined position and with a determined translational and rotational offset from the predetermined position.

**6.** A lithographic projection apparatus according to any one of the preceding Claims, wherein the non-contact edge sensor is an optical edge sensor.

**7.** A device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material;

**characterized by** determining the position and orientation of the substrate within a pre-alignment unit, prior to projecting the patterned beam of radiation onto the substrate, by:

- rotating the substrate about an axis of rotation substantially perpendicular to the plane of the substrate;
- using a non-contact edge sensor to determine the distance from said axis of rotation of the edge of the substrate along a measurement axis parallel to the plane of the substrate at a plurality of angles of rotation of the substrate;
- determining best-fit lines for at least two major edges of the substrate from the points associated with each edge that are defined by the determined distances and corresponding angles; and
- determining the position and orientation of the substrate within the pre-alignment unit from the determined best-fit lines;

and in that the pre-alignment unit is adapted to determine the position and orientation of a polygonal, planar substrate.

**8.** A computer program for operating a lithographic projection apparatus, said computer program comprising code means for instructing the apparatus to perform the following steps:

- calculating the position and orientation of a substrate in a pre-alignment unit; and
- using the calculated position and orientation of the substrate to control a transport means for positioning the substrate on a substrate table within a predetermined range of positions and orientations and with a known offset;

**characterized in that** the code means for calculating the position and orientation of the substrate in the pre-alignment unit comprises code means for performing the following steps:

- receiving a first plurality of data elements from a non-contact edge sensor, each data element corresponding to a distance of the edge of the substrate from an axis of rotation of the pre-alignment unit;
- receiving a second plurality of data elements, each corresponding to an angle of rotation of the substrate about the axis of rotation of the pre-alignment unit associated with one of the first plurality of data elements;
- calculating best-fit lines for at least two major edges of the substrate from first and second data elements associated with each edge; and
- calculating the position and orientation of the substrate in the pre-alignment unit from the best-fit lines;

and **in that** the pre-alignment unit is adapted to determine the position and orientation of a polygonal, planar substrate.

Fig. 1

Fig. 2

MS

ES

W

1

RA

## Fig. 3a

-X

-X ⟍ MS

-Y

RA

MSCS

-Y ———————————————— +Y

(C6+C6$_{offset}$)

ESCS

+Y

ES

+X

+X

## Fig. 3b

-X

| | |
|---|---|
| Q2 | Q1 |
| Q3 | Q4 |

W

-Y ———————————————— +Y

N

+X

## Fig. 4

```
┌─────────────────────┐
│    Receive Wafer    │
└─────────────────────┘
          │
          ▼◄───────────────────────┐
┌─────────────────────┐            │
│ Wafer rotated       │            │
│ through 360°        │            │
│ and 200 CCD values  │            │
│ acquired            │            │
└─────────────────────┘            │
          │                        │
          ▼                        │
┌─────────────────────┐            │
│ CCD values          │            │
│ converted to        │            │
│ array of radius     │            │
│ values              │            │
└─────────────────────┘            │
          │                        │
          ▼                        │
┌─────────────────────┐            │
│ Radius values       │            │
│ used to             │            │
│ determine offset    │            │
│ between GWCS and    │            │
│ ESCS               │            │
└─────────────────────┘            │
          │                        │
          ▼                        │
      ╱─────────╲          ┌──────────────┐
     ╱ Is        ╲   Yes   │ Center Wafer │
    ╱ geometrical ╲───────►└──────────────┘
    ╲ center of   ╱
     ╲ wafer      ╱
      ╲ outside  ╱
       ╲ spec?  ╱
        ╲──────╱
          │ No
          ▼
┌─────────────────────┐
│ If wafer has notch, │
│ orientation         │
│ determined in ESCS  │
└─────────────────────┘
          │
          ▼
┌─────────────────────┐
│ Position and        │
│ orientation of      │
│ wafer converted to  │
│ WCS                 │
└─────────────────────┘
          │
          ▼
```

Fig. 5

## Fig. 6

Determine radius of curvature for each point on edge. Compare with thresholds to identify lines. Reject the rest.

↓

Split ESCS into its four quadrants. For each identify "corner" point which has the largest radius

↓

Repeat for each "line" ↔ For all the points between two "corners", find best fit line using least squares fit. Store line parameters

↓

Analyse variation in distances of points from best fit line. Determine number more than 3 standard deviations ($3\sigma$) from line

↓

Is number above threshold?

— Yes → Reject all the points more than $3\sigma$ from line

— No ↓

Intersections of the four lines define the corners of the wafer

↓

Use "corners" from successful line

Geometric center is average position of corners. Orientation determined from average angle.

**European Patent Office**

**EUROPEAN SEARCH REPORT**

Application Number

EP 02 25 5085

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 6 195 619 B1 (REN JIE) 27 February 2001 (2001-02-27) * column 5, line 30 – column 9, line 44 * * figures 3-9 * | 1-8 | G03F7/20 G03F9/00 |
| X | PATENT ABSTRACTS OF JAPAN vol. 1997, no. 08, 29 August 1997 (1997-08-29) -& JP 09 090308 A (HITACHI ELECTRON ENG CO LTD), 4 April 1997 (1997-04-04) * abstract; figures * * paragraph '0016! * paragraph 16 refers to 4 as exposure optical system | 1-8 | |
| X | PATENT ABSTRACTS OF JAPAN vol. 1997, no. 10, 31 October 1997 (1997-10-31) -& JP 09 152569 A (HITACHI ELECTRON ENG CO LTD), 10 June 1997 (1997-06-10) * abstract; figures * * paragraphs '0001!,'0004! * paragraphs 1, 4 disclose aligner exposure optical system | 1-8 | |

TECHNICAL FIELDS SEARCHED (Int.Cl.7)

G03F
H01L
H05K

The present search report has been drawn up for all claims

| Place of search | Date of completion of the search | Examiner |
|---|---|---|
| THE HAGUE | 30 August 2002 | Heryet, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 02 25 5085

This annex lists the patent family members relating to the patent documents cited in the above-mentioned European search report.
The members are as contained in the European Patent Office EDP file on
The European Patent Office is in no way liable for these particulars which are merely given for the purpose of information.

30-08-2002

| Patent document cited in search report | | Publication date | Patent family member(s) | | Publication date |
|---|---|---|---|---|---|
| US 6195619 | B1 | 27-02-2001 | AU<br>EP<br>WO | 6952500 A<br>1204875 A1<br>0109630 A1 | 19-02-2001<br>15-05-2002<br>08-02-2001 |
| JP 09090308 | A | 04-04-1997 | JP | 3140349 B2 | 05-03-2001 |
| JP 09152569 | A | 10-06-1997 | NONE | | |